# EUROPÄISCHE PATENTSCHRIFT

(11) **EP 2 226 929 B1**
(45) Veröffentlichungstag und Bekanntmachung des Hinweises auf die Patenterteilung: **22.05.2013**
(21) Anmeldenummer: 09154565.7
(22) Anmeldetag: 06.03.2009
(51) Int. Cl.: H02P 21/04, H02P 21/14, G01R 31/34

(54) **Plausibilitäts-Überwachungssystem für Bewegungsmessungen an einer elektrischen Antriebseinrichtung**
Plausibility monitoring system for movement monitoring on an electrical drive device
Système de surveillance de la plausibilité pour des mesures de mouvements sur un dispositif d'entraînement électrique

(43) Veröffentlichungstag der Anmeldung: 08.09.2010
(73) Patentinhaber: Baumüller Nürnberg GmbH, 90482 Nürnberg (DE)
(72) Erfinder: Barinberg, Dr., Herr Viktor, 90491 Nürnberg (DE); Jütte, Herr Thomas, 90480 Nürnberg (DE); Heller, Herr Ulrich, 90552 Röthenbach (DE); Unger, Herr Tobias, 90489 Nürnberg (DE)
(74) Vertreter: Götz, Georg Alois

(56) Entgegenhaltungen:
- EP-A- 1 986 318
- EP-A- 2 023 479
- DE-A1-102006 045 397
- US-A1- 2004 189 239

## Beschreibung

Die Erfindung betrifft ein Verfahren zur Überwachung einer Bewegungsmessung an einer elektrischen Antriebseinrichtung auf Plausibilität. Dabei umfasst die Bewegungsmessung eine Erfassung von Ausgangssignalen eines die Bewegungen der Antriebseinrichtung sensierenden bzw. abtastenden Lage-, Geschwindigkeits- und/oder Beschleunigungs-Gebers. Ferner betrifft die Erfindung ein zur Durchführung dieses Verfahrens geeignetes Überwachungsmodul für eine elektrische Antriebseinrichtung mit einem Lage-, Geschwindigkeits- und/oder Beschleunigungsgeber und/oder mit einer Einrichtung auf, die zum Schätzen der Lage, Geschwindigkeit und/oder Beschleunigung anhand von Strommessungen in der Antriebseinrichtung ausgebildet ist (Schätzeinrichtung). Das Oberwachungsmodul weist wenigstens eine erste Eingangsschnittstelle für eine Bewegungssensorik und wenigstens eine Ausgangsschnittstelle zur Ansteuerung von Ausschaltmitteln für die Antriebseinrichtung oder von sonstigen Sicherheitsmitteln auf. Weiter betrifft die Erfindung eine Sicherheitsanordnung mit einem derartigen Überwachungsmodul, das eingangsseitig mit einem Geber für die Lage, Geschwindigkeit und/oder Beschleunigung der Antriebseinrichtung verbindbar oder verbunden ist.

Aus EP 2 023 479 A1 ist ein System zur nahtlosen Geschwindigkeits- und/oder Lageerniittlung einschließlich Stillstand bei einem Permanentmagnet-Läufer einer elektrischen Maschine bekannt. Für die höheren Geschwindigkeiten wird ein mathematisches Msschinenmodell verwendet, mittels welchem aus dem Einfluss einer den Statorstrom beeinflussenden Läufer-Rück-EMK auf die Läufer-Geschwindigkeit oder Läuferlage geschlossen und ein entsprechender Modell-Geschwindigkeitswert erzeugt wird. Für niedrigere Geschwindigkeiten bis einschließlich Stillstand wird ein Injektionsverfahren verwendet, bei dem stromführende Statorleiter mit einer Testsignalquellle gekoppelt werden. Die resultierenden Statorströme, beeinflusst von der Testsignalquelle, werden auf lageabhängige Anisothropien in der Magnetstruktur der elektrischen Maschine hin ausgewertet oder gefiltert. Hieraus lässt sich die Laufer-Geschwindigkeit und/oder Läuferlage der elektrischen Maschine erschließen und ein entsprechender Injektions-Geschwindigkeitswert erzeugen, aus dem mittels Integration über die Zeit die Läuferlage abgeleitet werden kann. Ziel dieses Verfahrens ist es, über den gesamten Geschwindigkeitsbereich des Permanentmagnetiäufers beispielsweise eines Synchronmotors ohne Bewegungssensorikensorik für die Läuferlage oder geschwindigkeit auszukommen.

Ferner sind elektrische Antriebseinrichtungen mit Bewegungssensorik in Form von Lagegebern weit verbreitet. Sollen diese erhöhten Sicherheitsanforderungen insbesondere gegenüber Lagegeberausfall genügen, lässt sich Abhilfe durch eine redundante Lagesensorik schaffen, nämlich indem beispielsweise dem ersten Lagegeber ein zweiter Referenz-Lagegeber zum Vergleich beigeordnet wird. Um diesen Zusatz-Aufwand zu vermeiden, wird in DE 10 2004 050 647 A1 ein Überwachungsverfahren für eine Antriebseinrichtung auf Stillstand vorgeschlagen, bei der, wenn Stillstand festgestellt wird, die Antriebseinrichtung mit Testsignalen beaufschlagt wird, um den Lagegeber auf Funktionsfähigkeit zu prüfen. Dazu wird das Ausgangssignal des Lagegebers mit sich zeitlich ändernden Testeingangssignalen moduliert. Enthält das Geberausgangssignal keine Signalkomponenten, die mit den eingeprägten Testsignalen korrespondieren, wird auf Geberausfall geschlossen und eine Sicherheitseinrichtung angesteuert.

In der Offenlegungsschrift DE 10 2006 045 397 A1 wird im Zusammenhang mit einer elektrischen Antriebsvorrichtung eine Fehlererkennung durch Auswertung von Größen einer feldorientierten Regelung beschrieben. Die geregelte elektrische Maschine ist mit einem Geber für Drehzahl, Lage oder Beschleunigung der Maschinenwelle versehen. Dieser Geber soll auf Fehler überwacht werden. Dazu wird eine Vergleichseinrichtung zum Vergleich des Gebersignals mit einer aus der feldorientierten Regelung errechneten Größe vorgesehen. Die Größe aus der feldorientierten Regelung betrifft ein entsprechendes Äquivalent zum Gebersignal. In der Vergleichseinrichtung werden zunächst das Gebersignal und die aus der feldorientierten Regelung errechnete Drehzahlgröße voneinander subtrahiert. Die resultierende Differenzgröße wird mittels eines Schweltwertvergleiches daraufhin überwacht, ob ein voreingestellter Schwellwert überschritten wird. Wenn ja, wird ein Fehlersignal generiert.

Dem gegenüber liegt der Erfindung die Aufgabe zugrunde, bei elektrischen Antriebseinrichtungen mit integrierten Sicherheitsfunktionen insbesondere gegenüber Geberausfall die Effektivität der Sicherheitsfunktionen zu erhöhen, ohne dass dabei sich der Hardware- oder Geräteaufwand spürbar erhöht. Zur Lösung wird auf das im Anspruch 1 angegebene Überwachungsverfahren sowie auf die nebengeordneten, unabhängigen Ansprüche auf ein Überwachungsmodul und eine Sicherheitsanordnung verwiesen. Optionale, vorteilhafte Ausgestaltungen des allgemeinen Erfindungskonzepts ergeben sich aus den abhängigen Ansprüchen.

Die Erfindung beruht auf der Grundidee, wenigstens zwei, vorzugsweise drei unabhängig gewonnene Lage- oder Winkelinformationen der Antriebseinrichtung gegeneinander zu prüfen. Das Erfindungskonzept umfasst eine Kombination einer Lage-, Geschwindigkeits- und/oder Beschleunigungsgeber-Messung oder -Auswertung mit einem Schätzverfahren zur Erkennung der Antriebslage, -geschwindigkeit und/oder -beschleunigung, beispielsweise über den Feldwinkel, insbesondere Statorfeldwinkel, innerhalb der Antriebseinrichtung. Besonders geeignet als Schätzverfahren ist das an sich bekannte Injektionsverfahren. Letzteres oder ein sonstiges Schätzverfahren (z. B. auch mathematisches Motormodell) können erfindungsgemäß zur Erkennung nicht korrekter Bewegungssensor- bzw. Geberinformationen genutzt werden, um einen Zustand funktionaler Sicherheit zu erreichen. Mit der Erfindung lassen sich ein oder auch mehrere Bewegungssensoren ohne zusätzliche Referenzgeber-Baueinheiten, ohne spezielle Referenzbewegungen und ohne Beschränkung auf besondere Bewegungszustände (beispielsweise Stillstand) sicherheitstechnisch überprüfen.

Erfindungsgemäß werden Strommessungen, die innerhalb der Antriebseinrichtung vielfach, beispielsweise im Rahmen einer Stromregelung zur Stromrückkopplung, ohnehin notwendig sind, zur Implementierung von Sicherheitsfunktionen verwendet. Mittels an sich bekannter Schätzverfahren (Motormodell und/oder Injektionsverfahren usw.) werden ein oder mehrere Schätzwerte zur Lage, Geschwindigkeit und/oder Beschleunigung des Läufers der elektrischen Antriebseinrichtung gebildet. Die Schätzwerte werden dann als Referenzwerte für die Überprüfung der Plausibilität der Geber-Ausgangssignale genutzt. Zweckmäßig werden beispielsweise die geschätzte (elektrische) Lage und die vom Lagegeber ausgegebene, physikalische Lage auf annähernde Übereinstimmung geprüft, was eine besonders einfache Verfahrensweise zur Überwachung der Plausibilität ergibt. Es sind für relativ hohe Antriebsgeschwindigkeiten geeignete Schätzverfahren (z. B. mathematisches Motormodell eines Synchronmotors mit Permanentmagnetläufer) als auch Schätzverfahren verfügbar, die für relativ niedrige Geschwindigkeiten einschließlich Stillstand geeignet sind (an sich bekannte Injektionsverfahren mit Einprägung von Testsignalen in die Statorströme). Damit lässt sich der Nachteil der aus der oben angesprochenen DE 10 2004 050 647 A1 resultierenden Beschränkung des Überwachungsverfahrens auf Stillstand vermeiden. Erfindungsgemäß ist die Plausibilitätsprüfung der sensierten Bewegung des Antriebs grundsätzlich über den gesamten Geschwindigkeitsbereich gegeben, ohne dass zusätzliche, redundante Bewegungssensaren notwendig sind. Die Antriebseinheit lässt sich auf der Basis der Erfindung sowohl im Stillstand als auch in der Bewegung überwachten, da die Schätzverfahren, gegebenenfalls verschiedene miteinander kombiniert, den gesamten Geschwindigkeitsbereich abdecken können.

Gemäß einer optionalen Erfindungsausbildung wird zur Statorfeldwinkelerkennung ein Injektionsverfahren eingesetzt, mittels dessen sich die Messung der lstbewegung mit einem Bewegungssensor gegen prüfen oder wenigstens plausibilisieren lässt. indem beim Injektionsverfahren bereits die Statorströme daraufhin gefiltert oder ausgewertet werden, ob Signalanteile korrespondierend mit injizierten Testsignalen enthalten sind, kann die Testsignalinjektion mit relativ hoher Frequenz erfolgen. Damit wird der Vorteil erzielt, dass sich die relativ hochfrequente Testsignalinjektion nicht in spürbare Bewegungen des Elektroantriebs bzw. des Läufers umzusetzen braucht. Mit der Erfindung lässt sich also der Vorteil erzielen, dass zur Plausibilitätsprüfung der Bewegungsmessung keine zusätzlichen mechanischen, störenden (Test-)Bewegungen ausgelöst werden.

Nach der Erfindung werden über ein vorbestimmtes Zeitintervall erfolgte Änderungen der Schätzwerte und der aus dem Geber gewonnenen Informationen verfolgt und verglichen. Konkreter: Aus einem ersten Geber-Measwert und einem diesen vorausgegangenen zweiten Geber-Messwert wird eine Messwertedifferenz gebildet; analog wird aus einem ersten und einem diesen vorausgegangenen zweiten Schätzwert eine Schätzwertedifferenz gebildet. Die Differenzwert-Bildung kann ein- oder mehrmals ertolgen. Die einen oder mehreren Geber-Mesewerte-Differenzen und die einen oder mehreren Schätzwerte-Differenzen werden dann darauf verglichen, ob sie übereinstimmen oder einander entsprechen. Durch diese Differenz-Bildungen lassen sich auf Offsets oder Drifts zurückgehende Mess- oder Auswertefehler vermeiden. Auch störende Temperatureinflüsse können kompensiert werden.

Optional lässt sich eine weitere Erhöhung der Sicherheit durch eine Zusatz-Plausibilitäts-Überwachung erreichen, indem noch eine weitere Lage- bzw. Winkel-, Geschwindigkeits- und/oder Beschleunigungsinformation über einen dritten, diversen Weg abgeleitet und in die Plausibilitätsprüfung mit einbezogen wird. Konkreter: Der dritte Weg besteht in der vorzugsweise direkten Messung von Strömen der Antriebseinrichtung, vorzugsweise Statorströme, und die Strommesswerte werden unter Bildung eines Strom- oder Spannungsraumzeigers ausgewertet. Die Lage, Geschwindigkeit und/oder Beschleunigung des Raumzeigers wird weiter mit dem einen oder den mehreren Schätzwerten und/oder Geber-Messwerten daraufhin verglichen, ob Entsprechung untereinander besteht.

Die erfindungsgemäße Plausibilitätsprüfung kann als Trigger oder Auslöser zur Ansteuerung von Sicherheitsmitteln bzw. zum Ergreifen von Sicherheitsmaßnahmen im Sinne der Herbeiführung eines schad- oder gefahrlosen Zustandes verwendet werden. Zweckmäßig werden so bei der Antriebseinrichtung, wenn sich eine Nicht-Entsprechung im Sinne des erfindungsgemäßen Plausibilisierungssystems feststellen lässt, deren Einschaltpfade gesperrt.

Die Erfindung manifestiert sich auch in einem Überwachungsmodul, das sich durch Eingangsschnittstellen für eine Bewegungssensorik an der Antriebseinrichtung und eine weitere Eingangsschnittstelle zum Empfang von Daten oder auch analogen Signalen aus der Schätzeinrichtung auszeichnet. Die Eingangsschnittstellen sind innerhalb des Überwachungsmoduls mit einer Vergleichseinrichtung daten- oder signaltechnisch verbunden. In letzterer werden die eingegangenen Signale, Daten oder Signal-oder Datenwerte entsprechend vorbestimmten Sicherheitskriterien auf Entsprechung untereinander ausgewertet und/oder verglichen.

Um im Sinne einer Optimierung der Sicherheit noch eine weitere Instanz für die Plausibilisierung zu gewinnen, wird nach einer optionalen Ausbildung das erfindungsgemäße Überwachungsmodul mit einer weiteren Eingangsschnittstelle versehen, die zum Empfang von Strommesswerten ausgelegt oder ausgebildet ist. Über diese Schnittstelle wird eine interne Recheneinrichtung mit den Strommesswerten entsprechenden Daten eingangsseitig parametriert, um den oben angesprochenen Strom- oder Spannungsraumzeiger zu ermitteln und ausgangsseitig einen Wert bzw. ein Datum für dessen Lage, Geschwindigkeit und/oder Beschleunigung zur weiteren Verarbeitung auszurechnen und zur Verfügung zu stellen. Über eine Zusatzvergleichseinrichtung kann dann dieser Wert für eine Zusatz-Plausibilisierung durch Vergleich mit Informationen aus dem Bewegungsgeber oder der Schätzeinrichtung genutzt werden.

Die Erfindung verkörpert sich auch in einer Sicherheitsanordnung, welche das Plausibilitäts-Überwachungsmodul und die Einrichtung zum Schätzen der Lage, Geschwindigkeit und/oder Beschleunigung anhand von Strommessungen an der Antriebseinrichtung umfasst. Eingangsseitig ist die Schätzeinrichtung mit einem oder mehreren Stromsensoren an der Antriebseinrichtung und ausgangsseitig mit dem Überwachungsmodul zur Zuführung intern berechneter Schätzwerte koppelbar. Eine beispielhafte, vorteilhafte Weiterbildung davon besteht darin, für das Überwachungsmodul noch zusätzlich eine direkte Kopplung mit den Stromsensoren vorzusehen.

Weitere Einzelheiten, Merkmale, Merkmalskombinationen, Vorteile und Wirkungen auf der Basis der Erfindung ergeben sich aus der nachfolgenden Beschreibung bevorzugter Ausführungsformen der Erfindung sowie aus den Zeichnungen. Diese zeigen in jeweils schematischer Darstellung:
- Figur 1: einen Wirkungsblockplan einer elektrischen Antriebseinrichtung mit einem Lage- und Geschwindigkeits-Ermittlungssystems zur erfindungsgemäßen Überwachung auf Plausibilität,
- Figur 2: ein Ablaufdiagramm zur Darstellung der Struktur des erfindungsgemäßen Plausibilitäts-Überwachungsverfahrens in einem Überwachungsmodul.

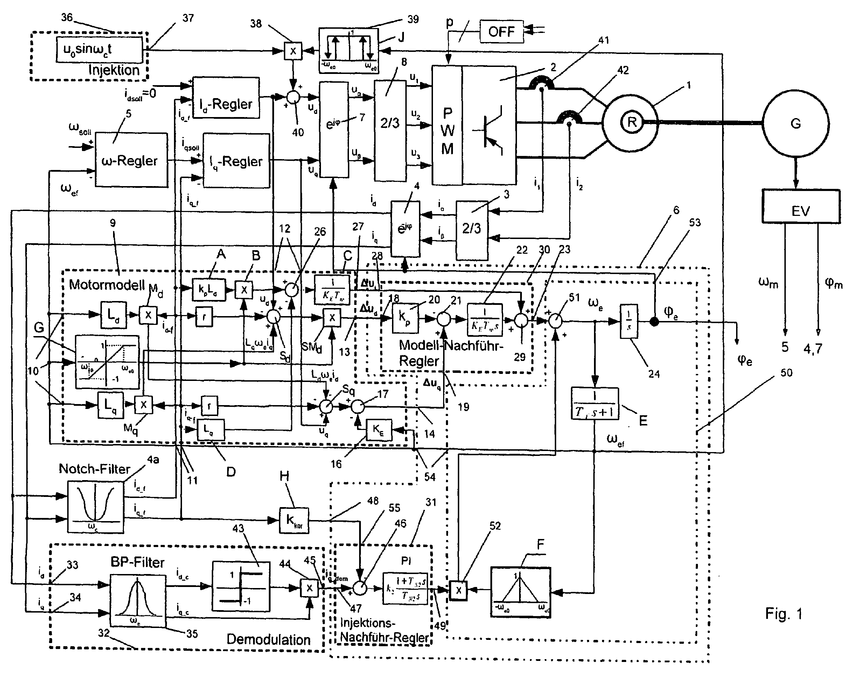

Gemäß Figur 1 ist der Stator 1 einer bürstenlosen elektrischen Maschine, beispielsweise eines Synchronmotors mit Permanentmagnet-Läufer (nicht gezeichnet), von einem auf der Basis von Pulsweitenmodulation (PWM) arbeitenden Umrichter 2 mit einem dreiphasigen Drehstrom betrieben. Für eine Stromregelung werden über Stromsensoren 41,42 vom Stator 1 die beiden Phasenströme i₁, i₂ abgegriffen bzw. gemessen, welche in einer 3-zu-2 Phasen-Transformationseinheit 3 auf ein statorbezogenes, orthogonales α, β-Koordinatensystem abgebildet werden. Im Zuge der Transformation werden zwei den Statorstrom repräsentierende α, β Vektorkomponenten i_{α}, i_{β} erzeugt und an eine zweite, nachgeordnete Koordinaten-Transformationseinheit 4 ausgegeben. Diese ist dazu ausgebildet, eine Koordinatentransformation vom statorbezogenen α,β-Koordinatensystem in ein rotorbezogenes d,q-Koordinatensystem mit der Ausgabe der Strom-Längs- und Quervektorkomponenten i_{α}, i_{β} vorzunehmen. Diese Strom-Vektorkompenten werden einem Notch- bzw. Kerbfilter 4a mit einer mittigen Sperrfrequenz, die einer injizierten Träger-Kreisfrequenz ω_{c} (siehe Erläuterungen weiter unten) entspricht, zugeführt. Es dient dazu, die durch die Injektion erscheinenden hochfrequenten Anteile aus den Strom-Längs- und Quervektorkomponenten i_{d}, i_{q} herauszufiltern. Die "nicht mehr verschmutzten" Strom-Vektorkomponenten i_{d-f} i_{q-f} am Kerbfilterausgang vom Statorstrom werden als Istwerte den Längsstrom- und Querstromreglern I_{d}, I_{q} zum Soll-/lstwert-Vergleich mit entsprechenden Längs- und Querstrom-Sollwerten i_{dsoll}, I_{qsoll} zugeführt, Wie an sich in der Fachwelt üblich, wird die Längsstrom-Sollwertvorgabe i_{dsoll} auf Null gesetzt, während der Querstromregler die Sollwertvorgabe I_{qsoll} von einem vorgeordneten Geschwindigkeitsregler 5 empfängt. Dieser geht von einem Vergleich eines Drehzahlsollwerts ωₛₒₗₗ mit dem von einem Fusionsmodul 6 ausgegebenen Schätz- bzw. Ermittlungswert für eine elektrische, tiefpassgefilterte (siehe Block E) Drehzahl ω_{ef} aus. Aus dem Fusionsmodul 6 wird ferner ein ermittelter elektrischer Winkel ϕₑ ausgegeben und der zweiten Transformationseinheit 4 sowie einer zu dieser komplementären dritten Transformationseinheit 7 zugeführt. Die dritte Transformationseinheit 7 empfängt ferner die von den Stromregiern I_{d}, I_{q} vorgegebenen Längs- und Querspannungs-Vektorkomponenten u_{d}, u_{q} und bildet diese in das statorbezogene α, β-Koordinatensystem mit den vorgegebenen Spannungsvektorkomponenten u_{α}, u_{β} ab. Letztere Spannungsvektorkomponenten werden von einer nachgeordneten, 2-zu-3-Phasen Transformationseinheit 8 empfangen, welche die Spannungsvorgabe in drei dem Drehstromsystem entsprechende Phasen u₁, u₂, u₃ für den nachgeordneten Umrichter 2 umsetzt.

Gemäß Figur 1 ist dem Fusionsmodul 6 ein Motor-Modellierungsmodul 9 vorgeordnet. Dieses weist Eingangsschnittstellen 10 für die ermittelte, gefilterte Drehzahl ω_{ef}, Eingangsschnittstellen 11 für die gemessenen in das d,q-Koordinatensystem abgebildeten und kerbgefilterten Längs- bzw. Querströme i_{d-f}, i_{q-f} und Eingangsschnittstellen 12 für die im d,q-Koordinatensystem vorgegebenen Längs- und Querspannungen u_{d}, u_{q} auf. Ferner weist das Modellierungsmodul 9 eine erste Ausgangsschnittstelle 13 für die Längsspannungsabweichung Δu_{d} und eine zweite Ausgangsschnittstelle 14 für die Querspannungsabweichung Δu_{q} auf.

Gemäß Figur 1 wird die über die Drehzahl-Eingangsschnittstellen 10 dem Motormodell 9 zugeführte, ermittelte, gefilterte Drehzahl ω_{ef} mit mehreren separaten Proportionalgliedern gewichtet, deren Verstärkungen der EMK-Konstante K_{E}, der Motor-Längsinduktivität L_{d} und der Motor-Querinduktivität Lq entsprechen. Ferner wird die eingegebene Drehzahl ω_{ef} noch mit einem Begrenzungsglied G gewichtet. Dieses hat für MaschinenGeschwindigkeiten, die außerhalb eines Intervalls bzw. Fensters für den kleineren, dem Injektionsverfahren zugeordneten Geschwindigkeitsbereich von -ωₑ₀ bis +ωₑ₀ liegen, also dem dem Motormodell zugeordneten, größeren Geschwindigkeitsbereich angehören, Vorzeichen- bzw. Signumsfunktion. Wird die Maschinen-Geschwindigkeit bzw. -Drehzahl sehr klein, dann sorgt der Abschnitt mit der vorzugsweis konstanten Steigung des Begrenzungsglieds G dafür, dass ein unstabiles Hin- und Herschalten zwischen positivem und negativem Vorzeichen vermieden ist. Das Begrenzungsglied G trägt also dazu bei, im Bereich der niedrigeren, dem Injektionsverfahren zugeordneten Drehzahlen dafür zu sorgen, dass auch aus dem Motormodell weiterhin stabilisierende Beiträge zur Gesamt-Geschwindigkeitsermittlung geliefert werden.

Die Ausgänge der Induktivitäts-Proportionalglieder L_{d}, Lq sind jeweils mit einem eigens zugeordneten Multiplizierglied M_{d}, Mq verbunden. Die zweiten Eingänge der Multiplizierglieder M_{d}, Mq sind jeweils mit der entsprechenden der beiden Strom-Eingangsschnittstellen 11 für (kerbgefilterten) Längs- bzw. Querstrom i_{d_f}, i_{q_f} verbunden. Die jeweiligen Ausgänge der Multiplizierglieder M_{d}, M_{q} sind Längsspannungs- bzw. Querspannungs-Summiergliedern S_{d}, S_{q} jeweils mit negativem (M_{d}) und positivem Vorzeichen (Mq) zugeführt. Einem jeweils zweiten Eingang der Längs- bzw. Quer-Spannungssummierglieder S_{d}, Sq sind über die Spannungs-Eingangsschnittstellen 12 die Längs- bzw. Querspannungsvorgaben u_{d}, u_{q} mit jeweils positivem Vorzeichen zugeführt. Die beiden Spannungs-Summierglieder S_{d}, S_{q} besitzen jeweils noch einen zusätzlichen Negativ-Eingang (mit jeweils negativem Vorzeichen), denen ein jeweiliger Ausgang der zwei vorgeordneten Proportionalglieder mit der dem ohmschen Motorwiderstand entsprechenden Verstärkung r zugeführt ist. Die beiden ohmschen Proportionalglieder r gewichten, wie bereits weiter oben angesprochen, die durch das Kerbfilter 4a gelangten Strom-Vektorkomponenten i_{d}__{f}, i_{q_f} mit dem ohmschen Motorwiderstand.

Gemäß Figur 1 ist das Begrenzungsglied G eingangsseitig mit der Geschwindigkeits-Eingangsschnittstelle 10 und ausgangsseitig mit dem ersten Eingang eines Vorzeichen-Multipliziergliedes SM_{d} verbunden. Dessen zweiter Eingang kommuniziert mit dem Ausgang des Längsspannungs-Summiergliedes S_{d}, und der Ausgang des Vorzeichen-Multipliziergliedes SM_{d} steht mit der ersten Ausgangsschnittstelle 13 für die Längsvektorkomponente Δu_{d} der Spannungsabweichung in Verbindung. Dadurch lässt sich die Richtung des Läufers der elektrischen Maschine in die Berechnung des Lageermittlungsfehlers mit einbeziehen.

Gemäß Figur 1 fließt bei der Berechnung des Geschwindigkeitsermittlungsfehlers in Form der Quervektorkomponente Δu_{q} der Spannungsabweichung noch die EMK-Motorkonstante über ein mit entsprechender Verstärkung dimensioniertes Proportionalglied 16 mit ein. Das EMK-Proportionalglied ist dazu eingangsseitig mit der Drehzahl-Eingangsschnittstelle 10 verbunden. Ausgangsseitig ist das EMK-Proportionalglied 16 mit dem Minus-Eingang eines EMK-Summierglieds 17 verbunden, dessen Plus-Eingang mit dem Ausgang des Querspannungs-Summierglieds Sq kommuniziert. Der Ausgang des EMK-Summierglieds 17 geht direkt auf die zweite bzw. Querspannungsabweichungs-Ausgangsschnittstelle 14 des Modellierungsmoduls 9 zur Ausgabe des Geschwindigkeitsermittlungsfehlers an das nachgeordnete Fusionsmodul 6.

Gemäß Figur 1 umfasst das Maschinen- bzw. Motormodell 9 ferner Induktivitäts-Proportionalglieder A, D mit der Längs- bzw. Querinduktivität L_{d}, L_{q} als jeweiliger Verstärkungsfaktor. Wie zeichnerisch angedeutet, kann dem Induktivitätsproportionalglied A in Reihenschaltung noch ein weiteres Proportionalglied vor- oder nachgeschaltet sein, das einem gleich oder gleichartig dimensionierten Proportionalglied 20 entspricht, welches in dem dem Motormodell 9 zugeordneten Modell-Nachführregler (siehe unten) integriert ist und dort als "Lageregulierungsglied" interpretiert werden kann. Dem Ausgang des für die Längsvektorkomponente i_{d}__{f} des kerbgefilterten Statorstromes zuständigen Induktivitäts-Proportionalgliedes A ist ein Multiplizierglied B nachgeordnet, dessen zweiter Eingang mit dem Ausgang des bereits genannten, im wesentlichen Vorzeichenfunktion erfüllenden Begrenzungsglieds G verbunden ist, wodurch die Richtung der Läuferdrehung oder Läufer-Linearbewegung mit einbezogen wird. Der Ausgang des Multipliziergliedes B ist auf den Plus-Eingang eines Induktivitäts-Summiergliedes 26 gelegt, dessen zweiter Eingang, verknüpft mit negativem Vorzeichen, mit dem Ausgang des für die gefilterte Stromvektor-Querkomponente i_{q_f} zuständigen Induktivitäts-Proportionalgliedes D mit der Motor-Querinduktivität Lq als Proportionalverstärkung verbunden ist. Der sich am Ausgang des Induktivitäts-Summiergliedes 26 ergebende Differenzwert wird noch mit einem zugeordneten bzw. nachgeschalteten Proportionalglied C gewichtet, das entsprechend der maschinenspezifischen EMK (elektromotorische Kraft)-Konstante K_{E} und der Zeitkonstante T_{ω}) dimensioniert und ausgangsseitig mit der dritten Ausgangsschnittstelle 27 für eine Induktivitäts-Spannungsabweichung Δu_{L} verbunden ist.

Gemäß Figur 1 umfasst das dem Motormodell 9 nachgeordnete Fusionsmodul 6 zwei simultan und voneinander unabhängig arbeitende Nachführregler, nämlich einen ersten Modell-Nachführregler 30 und einen zweiten Injektions-Nachführregler 31. Der Modell-Nachführregler 30 ist dem Motormodell 9, und der Injektions-Nachführregler 31 einem weiter unten beschriebenen Demodulationsmodul 32 zugeordnet.

Gemäß Figur 1 besitzt der Modell-Nachführregler 30 zwei Eingangsschnittstellen 18, 19 für die Längs- und Quervektorkomponenten Δu_{d}, Δu_{q} der im Modellierungsmodul 9 berechneten Spannungsabweichung. Die Längsvektorkomponente entspricht dem Lageermittlungsfehler, und die Quervektorkomponente dem Geschwindigkeitsermittlungsfehler. Die Eingangsschnittstelle 18 für die Längsspannungsabweichung Δu_{d} ist direkt dem Proportionalglied 20 zugeführt, welches mit der Proportionalverstärkung kp dimensioniert ist und ausgangsseitig mit dem Minus-Eingang eines ersten Nachführ-Summierglieds 21 verbunden ist. Dessen Plus-Eingang ist intern im Spannungs-Nachführ-Regler 30 direkt mit der Eingangsschnittstelle für die Querspannungsabweichung Δu_{q} verbunden. Das Summierergebnis wird ausgangsseitig einem ersten Integrationsglied 22 zugeführt, das erfindungsgemäß ohne Proportionalanteil ausgeführt und auf der Basis der EMK-Konstante K_{E} und einer Zeitkonstante T_{ω} bemessen ist. Der Ausgang des Integrationsgliedes 22, welches eine Integration der Differenz der Längs- und Querspannungsabweichung über die Zeit durchführt, ist dem Plus-Eingang eines zweiten Nachführ-Summiergliedes 29 zugeführt. Dessen zweiter Plus-Eingang ist intern im Modell-Nachführregler 30 mit dessen dritter Eingangsschnittstelle 28 verbunden. Letztere ist an die dritte Ausgangsschnittstelle 27 des Modellierungsmoduls 9 bzw. an den Ausgang des Proportionalgliedes C angelegt. Mithin wird der an der Ausgangsschnittstelle 27 des Modellierungsmoduls 9 ausgegebene Wert für die Induktivitäts-Spannungsabweichung Δu_{L} (welche die an sich von der Motorphysik geforderte interne Differenziation des Stromes im Motormodell ersetzt) der dritten Eingangsschnittstelle 28 des Modell-Nachführreglers 30 eingegeben. Intern wird die Spannungsabweichung Δu_{L} im Modell-Nachführregler 30 dem zweiten Plus-Eingang des zweiten Nachführ-Summierglieds 29 zugeführt. Dem anderen Plus-Eingang des zweiten Nachführ-Summierglieds ist der Ausgang des ersten Integrationsglieds 22 ebenfalls mit positiven Vorzeichen zugeordnet. Der Ausgang des zweiten Nachführ-Summierglieds führt zu einer Ausgangsschnittstelle 23 des Modell-Nachführreglers 30.

Gemäß Figur 1 liegen Eingangsschnittstellen 33, 34 des Demodulationsmoduls 32 parallel zum Kerbfilter 4a ebenfalls an den Ausgängen für rotorbezogene Vektorkomponenten i_{d}, iq der zweiten Koordinaten-Transformationseinheit 4 an. Die Eingangsschnittstellen 33, 34 führen zu einem Bandpass-Filter 35, dessen Durchlassfrequenz einer Träger-Kreisfrequenz ω_{c} entspricht. Auf der Basis dieser Träger-Kreisfrequenz ω_{c} arbeitet beziehungsweise schwingt eine Injektionssignalquelle 36, über deren Ausgang 37 ein Testsignal mit der Amplitude u₀ (beispielsweise 100 Volt bei Trägerfrequenz von beispielsweise 1 kHz) in die Statorströme i₁, i₂ eingekoppelt wird. Die Einkopplung erfolgt über den Eingang eines Multipliziergliedes 38, dessen zweiter Multiplikator-Eingang mit einem hysteresebehafteten Schaltglied 39 verknüpft ist. Dieses wird abhängig von der ermittelten, gefilterten Geschwindigkeit ω_{ef} angesteuert. Fällt der Betrag der ermittelten Geschwindigkeit ω_{ef} in ein zwischen den beiden Grenzfrequenzen ±ωₑ₀ gebildetes Fenster, gibt das Schaltglied den Wert eins an das Multiplizierglied 38 aus, und die Injektionssignalquelle 36 wird mit ihrem Ausgang 37 auf ein Reglerausgangs-Summierglied 40 durchgeschaltet. Dieses ist ausgangsseitig mit dem Längsspannungseingang der dritten Koordinaten-Transformationseinheit 7 verbunden, so dass über die beiden Transformationseinheiten 7, 8 ein zweckmäßig höherfrequentes Testsignal, welches die Träger-Kreisfrequenz ω_{c} enthält, über den Umrichter 2 in die Stromkreise des Stators 1 eingekoppelt und daraus über die beiden Strom-Sensoren 41, 42 von der ersten Transformationseinheit 3 wieder abgegriffen werden kann. Liegt die gefilterte, ermittelte Antriebsgeschwindigkeit ω_{ef} außerhalb des genannten Geschwindigkeits-Fensters -ωₑ₀ - +ωₑ₀, wird durch Null-Ausgabe des Schaltglieds 39 die Verbindung des Injektionsausgangs 37 zur Regler-Summierstelle 40 unterbrochen, was bei höheren Antriebs-Geschwindigkeiten zur Vermeidung von Störungen aufgrund der höherfrequenten Träger-Kreisfrequenz ω_{c} zweckmäßig ist.

Da die Träger-Kreisfrequenz ω_{c} der Injektionssignalquelle 36 bekannt ist, lässt sich beim Demodulationsmodul 32 das Bandpassfilter 35 mit seinem Durchlass-Bereich auf diese Träger-Kreisfrequenz ω_{c} fokussieren. Infolgedessen stehen am Ausgang des Bandpass-Filters 35 Strom-Vektorkomponenten i_{d}__{c}, i_{q_c} zur Verfügung, die als Frequenzanteile im Wesentlichen nur die Träger-Kreisfrequenz ω_{c} entsprechend dem über die Reglerausgangs-Summierstelle 40 eingespeisten Testsignal enthalten. Die vom Bandpassfilter herausgefilterte Strom-Vektor-Querkomponente i_{qc} entspricht einem von der magnetischen Anisotropie abhängigen Korrektursignal, worin Information über die Läuferlage enthalten ist. Wegen weiterer Einzelheiten und theoretischer Hintergründe darf auf die bereits oben genannte Fundstelle von O.C. Ferreira und R. Kennel "Encoderless control of ...", insbesondere dortige Figuren 3 und 4 mit zugehöriger Beschreibung, verwiesen werden. Danach ist es vorteilhaft, ein alternierendes Testsignal mit der hohen Träger-Kreisfrequenz ω_{c} nur der Spannungsvektor-Längskomponente u_{d} aus dem entsprechenden Reglerausgang einzuprägen bzw. zu überlagern, um nachteilige Einflüsse auf die für die Drehmomenterzeugung relevanten Strom/Spannungsvektor-Querkomponenten iq, u_{q}, zu vermeiden. Nach dem Herausfiltern der Trägerfrequenzstrom-Querkomponente i_{qc} im Demodulator 32 wird diese bezüglich der Trägerfrequenzstrom-Längskomponente i_{d_c} gleichgerichtet, was mittels eines Signumsgliedes 43 und eines Multipliziergliedes 44 erfolgt. Dazu wird die Längskomponente i_{d_c} des Trägerstromvektors aus dem Bandpass-Filter 35 dem Eingang des Signumsglieds 43 zugeführt. Dessen Ausgang ist mit einem Multiplikatoreingang verbunden. Der andere Multiplikatoreingang des Multiplizierglieds 44 ist mit dem Bandpass-Ausgang für die Querkomponente des Trägerstroms verbunden. Der Ausgang des Multiplizierglieds bildet gleichzeitig die Ausgangsschnittstelle 45 des Demodulators 32 für die demodulierten Hochfrequenzanteile i_{q_dem} des Querstroms iq.

In der eingangs genannten Fundstelle geben Ferreira und Kennel auf Seite 1966 in Verbindung mit Figur 6 den Hinweis, dass mit zunehmender mechanischer Last der Stator-Grundstrom zunimmt. Dadurch wird die Orientierung der Anisotropie, wie sie vom Injektions-Nachführregler 31 detektiert wird, verschoben, was in einen Winkelfehler resultiert, der durch eine Verschiebung des Sättigungsmaximums durch die Ständerstromvektor-Querkomponente verursacht wird, welche für die Erzeugung des Drehmoments relevant ist. Ein solcher fehlerhafter Versatz kann jedoch durch eine einfache lineare Adaption des Drehmoment erzeugenden Laststromes kompensiert werden. Dem dient das in Figur 1 gezeichnete Proportionalglied kₖₒᵣ (Block H) mit Fehlerkorrekturfunktion. Das Korrektur-Proportionalglied H wird mit dem über das Kerbfilter von Anteilen der Träger-Kreisfrequenz ω_{c} gereinigten Stator-Querstrom i_{q_f} eingangsseitig gespeist, und am Ausgang des Proportionalgliedes H steht ein stromabhängiges Kompensationssignal zur Verfügung. Nun lässt sich der Einfluss eines lastabhängigen Fehlers kompensieren, indem das stromabhängige Kompensationssignal aus dem Proportionalglied H einem Minus-Eingang eines Eingangs-Summiergliedes 46 zugeführt wird, dessen Plus-Eingang mit der Ausgangsschnittstelle 45 des Demodulators 32 verbunden ist.

Für den Injektions-Nachführregler 31 bildet die EingangsSummierstelle 46 die erste Eingangsstation bzw. die Stromwert-Eingangsschnittstelle 47 für den demodulierten Querstrom i_{q_dem}, und 48 bezeichnet die Eingangsschnittstelle für das stromabhängige Kompensationssignal. Das Summierergebnis wird ausgangsseitig auf einen Proportional-Integralregler PI geführt. Dessen Ausgang bildet die Ausgangsschnittstelle 49 des Injektions-Nachführreglers 31.

Gemäß Figur 1 umfasst das Fusionsmodul 6 auch eine Kombinationseinrichtung 50, welche Eingangsschnittstellen für die Ausgangsschnittstellen 23, 49 der beiden Nachführregler 30, 31 aufweist. Die Ausgangsschnittstelle 23 des Modell-Nachführreglers 30 ist direkt einem Plus-Eingang einer Fusions-Summierstelle 51 zugeführt. Der Ausgang 49 des Injektions-Nachführreglers 31 ist mit dem zweiten Plus-Eingang der Fusions-Summierstelle 51 mittelbar über einen Gewichtungsmultiplizierer 52 gekoppelt. Der zweite Multiplikator-Eingang des Gewichtungsmultiplizierers 52 ist mit dem Ausgang eines Betragsbildungsgliedes F verbunden. Dieses besitzt gemäß gezeichnetem Ausführungsbeispiel eine geschwindigkeitsabhängige Dach-Kennlinie, die aus zwei Schrägabschnitten zusammengesetzt ist, welche mit betragsmäßiger Zunahme der Geschwindigkeit abfallen beziehungsweise jeweils eine fallende/negative Steigung aufweisen. Die beiden vorzugsweise zueinander symmetrischen Abschnitte treffen sich in dem Gewichtungswert "1" bei der Geschwindigkeit Null in einem Winkel. Ferner weist die Kennlinie des Betragsbildungsgliedes F zwei Nullstellen auf, die den beiden genannten Grenz-Geschwindigkeiten ± ωₑ₀ entsprechen. Liegt der Betrag der ermittelten, gefilterten Geschwindigkeit ω_{ef} am Eingang des Betragsbildungsgliedes F außerhalb des sich von -ωₑ₀ bis +ωₑ₀ erstreckenden Geschwindigkeitsintervalls, wird der Ausgang 49 des Injektions-Nachführreglers 31 mit "Null" gewichtet bzw ausgeblendet Andernfalls wird der Injektions-Nachführregler-Ausgang 49 um so stärker gewichtet, je mehr sich die ermittelten Geschwindigkeitsbeträge |ω_{ef}| dem Wert Null annähern bzw, je kleiner der Antriebsgeschwindigkeits-Betrag wird. Dafür sorgt die geschwindigkeitsabhängige, vom Geschwindigkeitswert Null bidirektional jeweils abfallende Kennlinie des Betragsbildungsgliedes F. Dessen Eingang wird vom Ausgang der Fusions-Summierstelle 51 aus gespeist, vorzugsweise mittelbar über ein zwischengeschaltetes Tiefpass-Filter bzw. PT₁-Glied E, über welches aus der ermittelten Antriebs-Geschwindigkeit ωₑ am Ausgang der Fusions-Summierstelle 51 eine gefilterte, ermittelte Antriebs-Geschwindigkeit ω_{ef} erzeugt wird. Während bei Antriebs-Geschwindigkeits-Beträgen größer als der Grenz-Geschwindigkeitsbetrag ±ωₑ₀ der Injektions-Nachführregler 31 an seinem Ausgang 49 durch entsprechende Gewichtung ausgeblendet wird, bleibt bei kleinen Geschwindigkeiten innerhalb des genannten Fensters bzw. Intervalls von - ωₑ₀ bis +ωₑ₀ der Modell-Nachführregler 30 grundsätzlich weiter aktiv bzw, mit seinem Ausgang 23 zur Fusions-Summierstelle 51 durchgeschaltet. Dadurch liefert der Modell-Nachführregler auch bei kleinen Drehzahlen, wo an sich die Maschinen-Rück-EMK zur Auswertung und Ermittlung der Läuferlage zu schwach ist, weiterhin Beiträge, welche die bei niedrigen Geschwindigkeiten relevanten Werte aus dem Injektions-Nachführregler 31 stabilisieren und ergänzen. Die Genauigkeit ist so für Geschwindigkeitswerte innerhalb des genannten Geschwindigkeits-Intervalls -ωₑ₀ bis +ωₑ₀ erhöht.

Ferner wird intern in der Kombinationseinrichtung 50 die am Ausgang der Fusions-Summierstelle 51 zur Verfügung stehende, ermittelte Antriebs-Geschwindigkeit/Drehzahl noch einem zweiten Integrationsglied 24 zugeführt, welches daraus in an sich bekannter Weise die elektrische AntriebsLage bzw. Winkellage ϕₑ per Integration über die Zeit berechnet und über eine Lage-Ausgangsschnittstelle 53 an die zweite und dritte Koordinaten-Transformationseinheit 4, 7 ausgibt, wodurch die Transformation zwischen dem stator- und rotorbezogenen Koordinatensystemen gesteuert wird. Die nach dem Tiefpass oder PT₁-Glied E ermittelte, gefilterte Antriebs-Geschwindigkeit ω_{ef} steht am Ausgang 54 der Kombinationseinrichtung 50 bzw. des Fusionsmoduls 6 zur weiteren Rückkopplung an das Modellierungsmodul 9 (Geschwindigkeits-Eingangsschnittstellen 10) sowie an den Geschwindigkeitsregler 5 zur Verfügung.

Gemäß Figur 1 ist, um die sensorlose Regelung, insbesondere das Arbeiten des Motormodells und/oder des Injektions-Demodulationsmoduls und der jeweiligen Nachführ-Reglers auf Plausibilität sicherheitstechnisch überwachen zu können, noch ein Winkellagegeber G angeordnet, der mit einem Rotor R einer den Stator 1 aufweisenden Antriebseinrichtung gekoppelt ist. Die Kopplung kann in einer Abtastung oder sonstigen Winkellagesensierung bestehen.

Alternativ zur beschriebenen, sensorlosen Regelung, d. h. Regelung ohne Winkellagegeber, kann auch ein Winkellage-Datum ϕₘ aus einer Auswerteeinheit EV, welche dem Winkellage-Geberausgang direkt nachgeschaltet ist, als Istwert anstelle der geschätzten elektrischen Winkellage ϕₑ den zweiten und dritten Transformationseinheiten 4, 7 zugeführt werden. Analog wird eine aus dem Geber G über die Auswerteeinheit EV abgeleitete, "gemessene" Winkelgeschwindigkeit ωₘ anstelle der ermittelten, gefilterten Drehzahl ω_{ef} dem ω-Regler 5 zugeführt. Die geschätzte, elektrische Winkellage ϕₑ wird dann nicht für die interne feldorientierte Regelung verwendet, sondern der nachfolgend beschriebenen Plausibilitäts-Überwachung zur Verfügung gestellt.

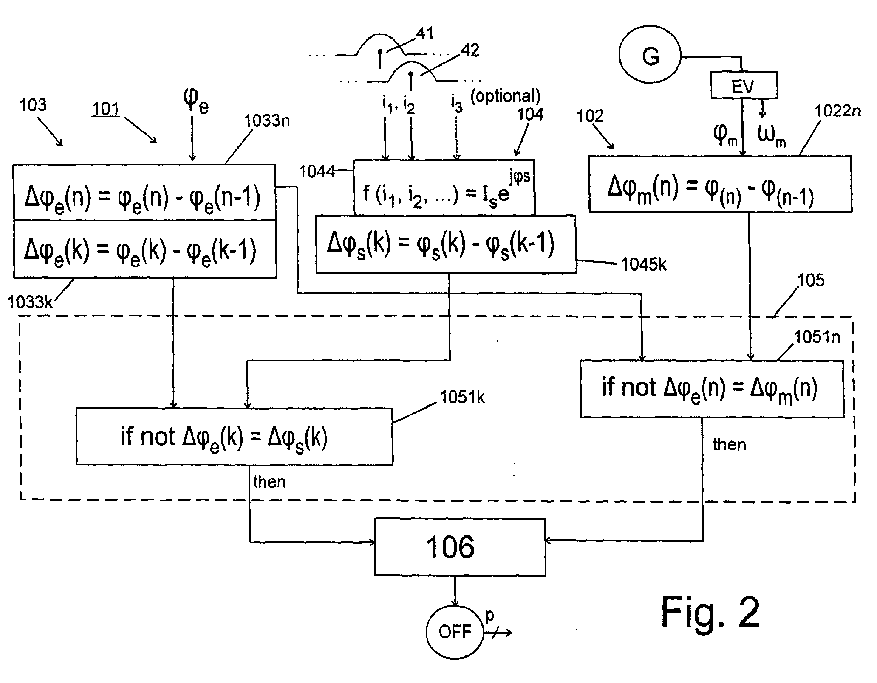

Gemäß Figur 2 ist das Überwachungsmodul 101 mit einer ersten, zweiten und dritten Eingangsschnittstelle 102, 103, 104 versehen. Die erste Eingangsschnittstelle 102 ist direkt mit dem Ausgang des Winkellagegebers G verbunden und umfasst ein Differenzbildungsrechenwerk 1022n, das vorzugsweise programmtechnisch zur Bildung einer Messwertedifferenz Δϕₘ(n) ausgebildet ist. Die Differenzbildung wird zweckmäßig zyklisch durchgeführt, indem von einem Geber-Messwert ϕₘ(n) eines aktuellen Abtastzeitpunktes n ein zweiter Geber-Messwert ϕₘ(n-1) eines vorausgegangenen Abtastzeitpunktes n-1 subtrahiert wird.

Gemäß Figur 2 ist die dritte Eingangsschnittstelle 104 mit den Stromsensoren 41, 42 verbunden, welche Messwerte über Stator-Phasenströme i₁, i₂ (optional i₃) liefern. Aus den Strommesswerten i₁, i₂ wird mittels eines Funktionsrechenwerkes 1044 in an sich in der Fachwelt bekannter Weise ein Statorstrom-Raumzeiger I_{S}e^{jϕs} berechnet und daraus der Stator-Raumzeigerwinkel ϕ_{S} dem Eingang eines der dritten Eingangsschnittstelle 104 zugeordneten Differenzbildungsrechenwerks 1045k zur Verfügung gestellt. Darin wird, analog dem Differenzbildungsrechenwerk 1022n der ersten Eingangsschnittstelle 102, ein Statorraumzeiger-Winkeldifferenzwert Δϕ_{S}(k) aus einem Stator-Raumzeigerwinkel ϕ_{S}(k) eines Abtastzeitpunktes k und einem anderen Stator-Raumzeigerwinkel ϕ_{S}(k-1) eines beispielsweise vorausgegangenen Abtastzeitpunktes k-1 berechnet. Die Abtastzeitpunkte k, k-1 für den einen und den vorausgegangenen anderen Statorraumzeigerwinkel brauchen nicht mit den Abtastzeitpunkten n, n-1 für die Gebermesswerte ϕₘ übereinzustimmen. Entsprechendes gilt für die Zwischenzeitintervalle zwischen einem ersten und einem vorausgegangenen zweiten Abtastzeitpunkt n, n-1, k, k-1. Zweckmäßige Zwischenzeitintervalle können in der Größenordnung von beispielsweise einer Millisekunde bis etwa hundert Millisekunden liegen.

Gemäß Figur 2 ist der zweiten Eingangsschnittstelle 103 ein Schätzwert für eine geschätzte, elektrische Winkellage ϕₑ des Statorfeldes zugeführt. Die zweite Eingangsschnittstelle 103 umfasst ein erstes Differenzbildungsrechenwerk 1033n und ein zweites Differenzbildungsrechenwerk 1033k jeweils zur Bildung einer Schätzwerte-Differenz Δϕₑ(n), Δϕₑ(k) über die elektrische, geschätzte Winkellage ϕₑ. Beide arbeiten analog den Differenzbildungsrechenwerken 1022n, 1045k der ersten und dritten Eingangsschnittstellen 102,104, wobei die Abtastzeitpunkte des ersten Differenzbildungsrechenwerks 1033n mit den Abtastzeitpunkten n, n-1 des Differenzbildungsrechenwerks 1022n der ersten Eingangsschnittstelle 102 und die Abtastzeitpunkte des zweiten Differenzbildungsrechenwerks 1033k mit den Abtastzeitpunkten k, k-1 des Differenzbildungsrechenwerks 1045k der dritten Eingangsschnittstelle 104 korrespondieren.

Gemäß Figur 2 ist mit den Ausgängen der ersten, zweiten und/oder dritten Eingangsschnittstelle 102, 103, 104 bzw. ihrer jeweiligen Differenzbildungsrechenwerke eine Plausibilisierungsfunktionseinheit 105 verbunden. In dieser sind ein erstes Plausibilitätsprüfungsorgan 1051 n und ein zweites (Zusatz-) Plausibilitätsprüfungsorgan 1051 k implementiert. Bei der ersten Plausibilitätsprüfung 1051 n wird die Schätzwerte-Differenz Δϕₑ(n) mit der Messwerte-Differenz Δϕₘ(n) auf der Basis der ersten Abtastzeitpunkte n, n-1 auf Übereinstimmung verglichen. Bei der zweiten beziehungsweise Zusatz-Plausibilitätsprüfung 1051 k werden die Schätzwerte-Differenz Δϕₑ(k) mit der Statorraumzeiger-Differenz Δϕₛ, ebenfalls auf der Basis der zweiten Abtastzeitpunkte k, k-1 auf Übereinstimmung verglichen. Liefert die erste und/oder zweite Plausibilitätsprüfung 1051 n, 1051 k ein Nicht-Übereinstimmung anzeigendes Flag, dann werden in einer eingangsseitig mit dem Ausgang der Plausibilisierungsfunktionseinheit 105 verbundenen Sicherheitsfunktionseinheit 106 vorbestimmte Sicherheitsmaßnahmen angestoßen, beispielsweise Sperrung der Einschaltpfade der in Figur 1 dargestellten Antriebseinrichtung. Zu letztgenanntem Zweck ist die Sicherheitsfunktionseinheit 106 ausgangsseitig mit Sperrmitteln OFF für eine Anzahl p Phasenströme verbunden, um im Falle eines fehlende Plausibilität anzeigenden Flag (Nicht-Übereinstimmung bzw. Nicht-Entsprechung der Differenzwerte) die Sperrmittel zur Unterbrechung der Einschaltpfade der Antriebseinrichtung, gemäß Figur 1 vorzugsweise im Bereich des Pulsweitenmodulators PWM anzusteuern.

### Bezugszeichenliste

- 1: Stator
- 2: Umrichter
- 3: 3-zu-2 Phasen-Transformationseinheit
- 4: zweite Koordinaten-Transformationseinheit
- 4a: Kerbfilter
- i_{α}, i_{β}: Vektor-Stromkomponenten im statorbezogenen α, β-Koordinatensystem
- i_{d}, iq: Vektor-Stromkomponenten im rotorbezogenen d,q-Koordinatensystem
- i_{dsoll}, i_{qsoll}: Längs- bzw. Querstromsollwert
- I_{d}, I_{q}: Längs- und Querstromregler
- 5: Geschwindigkeitsregler
- 6: Fusionsmodul
- ωₛₒₗₗ: Drehzahlsollwert
- E: Tiefpass
- ω_{ef}: ermittelte, gefilterte Drehzahl
- ϕₑ: ermittelte elektrische Winkellage
- 7: dritter Koordinaten-Transformationseinheit
- u_{d}, _{uq}: Längs- bzw. Querspannungsvorgaben
- u_{α}, u_{β}: Spannungsvorgabe im α, β-Koordinatensystem (statorbezogen)
- 8: 2-zu-3 Phasen-Transformationseinheit
- u₁, u₂, u₃: Spannungsvorgabe für drei Phasen
- 9: Motor-Modellierungsmodul
- 10: Drehzahl-Eingangsschnittstellen
- 11: Strom-Eingangsschnittstellen
- 12: Spannungs-Eingangsschnittstelle
- 13, 14: erste und zweite Ausgangsschnittstelle für intern berechnete Spannungsabweichungs-Vektorkomponenten
- K_{E}: EMK-Konstante
- G: Begrenzungsglied
- M_{d}, M_{q}: Multiplizierglieder
- S_{d}, S_{q}: Spannungssummierglieder
- VS_{d}, VS_{q}: Vorsummierglieder
- r: Proportionalglied für Motorwiderstand
- sL_{d}, sL_{q}: Längs-, Querstrom-Differenzierglied
- SM_{d}: Vorzeichen-Multiplizierglied
- Δu_{d}: Abweichungs-Längsvektorkomponente der Spannungsab-weichung
- Δu_{q}: Abweichungs-Quervektorkomponente der Spannungsabweichung
- 16: EMK-Proportionalglied
- 17: EMK-Summierglied
- 18, 19: Eingangsschnittstellen für Längs- und Querspannungsabweichung
- 20: Proportionalglied
- 21: erstes Nachführ-Summierglied
- 22: erstes Integrationsglied
- 23: erste Nachführregler-Ausgangsschnittstelle
- 24: zweites Integrationsglied
- 25: zweite Nachführregler-Ausgangsschnittstelle
- A,D: Induktivitäts-Proportionalglieder
- B: Multiplizierglied
- 26: Induktivitäts-Summierglied
- C: Proportionalglied
- 27: dritte Ausgangsschnittstelle
- 28: dritte Eingangsschnittstelle
- 29: zweites Nachführ-Summierglied
- 30: Modell-Nachführregler
- 31: Injektions-Nachführregler
- 32: Demodulationsmodul
- 33, 34: Eingangsschnittstellen
- 35: Bandpass-Filter
- ω_{c}: Träger-Kreisfrequenz
- 36: Injektionssignalquelle
- 37: Ausgang
- 38: Multiplizierglied
- 39: Schaltglied
- 40: Reglerausgangs-Summierglied
- 41,42: Stromsensor
- 43: Signumsglied
- 44: Multiplizierglied
- 45: Ausgangsschnittstelle
- i_{q_dem}: demodulierte Hochfrequenzanteile des Querstroms iq
- H: Proportionalglied zur Lastfehler-Korrektur
- 46: Eingangssummierstelle
- 47,48: Eingangsschnittstellen
- PI: Proportional-Integralregler
- 49: Ausgangsschnittstelle
- 50: Kombinationseinrichtung
- 51: Fusions-Summierstelle
- 52: Gewichtungsmultiplizierer
- 53: Lage-Ausgangsschnittstelle
- 54: Geschwindigkeits-Ausgang der Kombinationseinrichtung beziehungsweise des Fusionsmoduls
- F: Betragsbildungsglied
- 55: Lastfehler-Korrektureingang
- G: Winkellagegeber
- R: Rotor
- EV: Geber-Auswertung
- ϕₘ: Winkellage-Messwert
- ωₘ: Winkelgeschwindigkeits-Messwert
- 101: Überwachungsmodul
- 102, 103, 104: erste, zweite, dritte Eingangsschnittstelle
- 1022n: Differenzbildungs-Rechenwerk der ersten Eingangsschnittstelle 102
- Δϕₘ(n): Messwerte-Differenz
- ϕₘ(n): aktueller Geber-Messwert
- n: aktueller Abtastzeitpunkt
- ϕₘ(n-1): vorausgegangener, zweiter Geber-Messwert
- n-1: vorausgegangener Abtastzeitpunkt
- i₁, i₂, i₃: Phasenstrommesswerte
- 1044: Funktionsrechenwerk
- I_{S}e^{jϕS}: Statorstromraumzeiger
- ϕ_{S}: Statorraumzeigerwinkel
- 1045k: Differenzbildungsrechenwerk der dritten Eingangsschnittstelle 104
- Δϕ_{S}(k): Statorraumzeiger-Winkeldifferenzwert
- ϕ_{S}(k): aktueller Stator-Raumzeigerwinkel
- k: aktueller Abtastzeitpunkt
- ϕₛ(k-1): anderer Statorraumzeigerwinkel
- k-1: vorausgegangener Abtastzeitpunkt
- 1033n: erstes Differenzbildungsrechenwerk der zweiten Eingangsschnittstelle 103
- 1033k: zweites Differenzbildungsrechenwerk der zweiten Eingangsschnittstelle 103
- Δϕₑ(n), Δϕₑ(k): Schätzwerte-Differenz
- 105: Plausibilisierungsfunktionseinheit
- 1051n: Vergleichseinrichtung
- 1051k: Zusatz-Vergleichseinrichtung
- 106: Sicherheitsfunktionseinheit
- OFF: Sperrmittel
- p: Anzahl Phasenströme
- PWM: Pulsweitenmodulator

## Patentansprüche

1. Verfahren zur Überwachung einer Bewegungsmessung an einer elektrischen Antriebseinrichtung (Fig.1) auf Plausibilität wobei die Bewegungsmessung eine Erfassung von Ausgangangssignalen eines Bewegungen der Antriebseinrichtung senslerenden Lage-, Geschwindigkeits- und/oder Beschleunigungs-Gebers (G) umfasst, und die Plausibllitäts-Überwachung folgende Schritte umfasst:
a) Messungen von elektrischen Strömen (41,i1;42,i2) in der Antriebseinrichtung (Fig.1),
**gekennzeichnet durch** die weiteren Schritte:
b) anhand der Messungen der elektrischen Ströme (41,i1;42,i2) werden ein oder oder mehrere Schätzwerte (ϕe) für die Lage, Geschwindigkeit und/oder Beschleunigung der Antriebseinrichtung erzeugt,
c) der oder die Schätzwerte (ϕe) werden auf Entsprechung mit einem oder mehreren, aus den Geber-Ausgangssignalen erzeugten Messwerten (ϕm) verglichen, wobei aus einem Geber-Messwert ( ϕm(n)) und einem diesem vorausgegangenen Geber-Messwert ( ϕm(n-1)) eine Messwerte-Differenz ( Δϕm(n) ), und analog aus einem ersten und einem diesem vorausgegangenen zweiten Schätzwert (ϕe(n), ϕe(n-1) ) eine SchätzwerteDifferenz ( Δϕe(n) ) gebildet, und die einen oder mehreren Geber Messwerte-Differenzen ( Δϕm(n) ) und die einen oder mehreren Schätzwerte-Differenzen ( Δϕe(n)) auf Entsprechung miteinander verglichen werden.

2. Verfahren nach Anspruch 1, **dadurch gekennzeichnet, dass** die Ströme (i1,i2) der Antriebseinrichtung (Fig.1) mit Testsignalen aus wenigstens einer Testsignalquelle (36) beaufschlagt oder beeinflusst werden.

3. Verfahren nach Anspruch 2, **dadurch gekennzeichnet dass** zur Erzeugung des oder der Schätzwerte (ϕe) gemäß Schritt a) ein auch für Stillstand geeignetes Injektionsverfahren verwendet wird, bei dem die mit dem oder den Testsignalen beaufschlagten Ströme (I1,i2) auf lageabhängige Anisotropen In der Magnetstruktur einer elektrischen Maschine der Antriebseinrichtung (Fig.1) hin ausgewertet und/oder gefiltert werden, und daraus die Lage (ϕe), Geschwindigkeit (ω_{ef}) und/oder - Beschleunigung der Antriebseinrichtung geschätzt wird.

4. Verfahren nach Anspruch 1, 2 oder 3, **dadurch gekennzeichnet, dass** für die Antriebseinrichtung (Fig.1) ein Elektromotor mit einem von den Strömen (i1,i2) durchflossenen Stator (1) verwendet wird, und zur Erzeugung des oder der Schätzwerte gemäß Schritt a) ein mathematisches Maschinenmodell (9) verwendet wird, bei welchem aus dem Einfluss einer einen Statorstrom (i₁,i₂) beeinflussenden Läufer-Rück-EMK auf die Läufer-Geschwindigkeit (we) und/oder -Lage (ϕe) geschlossen und ein entsprechender Modell-Geschwindigkeitswert (13,19,23) oder Lagewert (ϕe) erzeugt wird.

5. Verfahren nach einem der vorangehenden Ansprüche, wobei für die Antriebseinrichtung (Fig.1) ein Elektromotor mit einem von den Strömen (i1,i2) durchflossenen Stator (1) verwendet wird, **gekennzeichnet durch** eine gegebenenfalls zusätzliche Plausibilitäts-Überwachung, bei der die Statorströme (iₗ,i₂) gemessen (41,42), und die resultierenden Statorstrom-Messwerte unter Bildung eines Statorraumzeigers ( Ise^{jϕs}) ausgewertet werden, und der eine oder die mehreren Schätzwerte (ϕe), die aus den Strom-Messungen (41,i1;42,i2) in der Antriebseinrichtung (Fig.1) zur Ermittlung der Lage, Geschwindigkeit und/oder Beschleunigung der Antriebseinrichtung (Fig.1) resultieren, und/oder die Geber-Messwerte (ϕm) für die Lage, Geschwindigkeit und/oder Beschleunigung der Antriebseinrichtung auf Entsprechung mit der Lage (ϕS), Geschwindigkeit und/oder Beschleunigung des Statorraumzeigers ( Ise^{jϕs}) verglichen werden.

6. Verfahren nach Anspruch 5, **dadurch gekennzeichnet, dass** aus einer Winkellage (ϕS(k)), Winkelgeschwindigkeit und/oder Winkelbeschleunigung des Statorraumzelgers ( Ise^{jϕs} ) und einer dieser vorausgegangenen Winkellage (ϕS(k-1)), Winkelgeschwindigkeit und/oder Winkelbeschleunigung des Statorraumzeigers ( Ise^{jϕs}) ein Differenzwert (ΔϕS(k)) für die Lage-, Geschwindigkeits- und/oder Beschleunigungsänderung des Statorraumzeigers ( Ise^{jϕs} ), und jeweils analog aus einem ersten und einem diesem vorausgegangenen zweiten Messwert (Δϕm(n), Δϕm(n-1)) eine Messwerte-Differenz (Δϕm), und/oder aus einem ersten und einem diesem vorausgegangenen zweiten Schätzwert (ϕe(k) ϕe(k-1)) eine oder mehrere Schätzwerte-Differenzen (Δϕe(n), Δϕe(k)) gebildet werden, und die Messwerte- und/oder Schätzwerte-Differenzen (Δϕe(k)) auf Entsprechung mit dem Statorraumzeiger-Differenzwert (Δϕe(k)) verglichen werden.

7. Verfahren nach einem der vorangehenden Ansprüche, **dadurch gekennzeichnet, dass** eine Sperrung oder Unterbrechung der Einschaltpfade oder sonstigen Einschaltmittel der Antriebseinrichtung (Fig.1) und/oder eine Ansteuerung von Ausschaltmitteln (OFF) für die Antriebseinrichtung oder von sonstigen Sicherheitsmitteln oder - maßnahmen erfolgt, wenn bei einem Plausibilitätsvergleich (105) eine fehlende Entsprechung festgestellt wird.

8. Überwachungsmodul (101) für eine elektrische Antriebseinrichtung (Fig.1) mit einem Lage-, Geschwindigkeits- und/oder Beschleunigungsgeber (G) und mit einer Vergleichseinrichtung (1051n) oder sonstigen Plausibilislerungs-Funktlonseinheit(105), welche schaltungs- und/oder programmtechnisch dazu eingerichtet und/oder ausgebildet ist, eingegangene Signale, Daten oder Signal- oder Datenwerte auf Entsprechung miteinander nach vorbestimmten Kriterien zu vergleichen, wobei das Überwachungsmodul (101) wenigstens eine erste Eingangsschniftstelle (102) für eine Bewegungssensorik (G) und wenigstens eine Ausgangsschnittstelle (106,OFF) zur Ansteuerung von Ausschaltmitteln für die Antriebseinrichtung (Fig.1) oder sonstigen Sicherheitsmitteln aufweist, insbesondere zur Durchführung des Verfahrens nach einem der vorangehenden Ansprüche, **dadurch gekennzeichnet, dass** das Überwachungsmodul (101) eine Einrichtung (9,30;32,31) zum Schätzen der Lage (ϕe), Geschwindigkeit und/oder Beschleunigung anhand von internen Strommessungen (41,i1;42,i2) und eine zweite Eingangsschnittstelle (103) für den Ausgang (ϕe) der Schätz-Einrichtung (9,30;32,31) aufweist, und mit den Ausgängen der ersten und der zweiten Eingangsschnittstelle (102,103) wenigstens ein Eingang der Vergleichseinrichtung (1051n) oder sonstigen Plausibilisierungs-Funktionseinheit(105) verbunden Ist, wobei die erste und zweite Eingangsschnittstelle (102,103) jewelis ein Differenzbildungs-Rechenwerk (1022n, 1033n, 1033k) umfassen, welches aus einem ersten und einem vorausgegangenen zweiten Eingangswert ausgangsseitig einen Differenzwert ausgibt, und die Vergleichseinrichtung (1051n) jeweils mit einem der Ausgänge zweier Differenzbildungs-Rechenwerke (1033n,1022n) verbunden sind.

9. Überwachungsmodul nach Anspruch 8, **gekennzeichnet durch** eine zum Empfang von Strommesswerten (i1,i2,i3) ausgelegte, dritte Eingangsschnittstelle (104), mit welcher eingangsseitig eine Recheneinrichtung (1044) verbunden oder baulich und/oder funtionell integriert ist, welche schaltungs- und/oder programmtechnisch dazu eingerichtet und/oder ausgebildet ist, aus den Strommesswerten (i1,i2) einen Strom- oder Spannungsraumzeiger ( Ise^{jϕe}) zu ermitteln und ausgangsseitig einen Wert (ϕs) für dessen Lage, Geschwindigkeit und/oder Beschleunigung zur Verfügung zu stellen, und der Ausgang dieser Recheneinrichtung (1044) mittel. oder unmittelbar mit einem ersten Eingang einer Zusatz-Vergleichseinrichtung (1051k) verbunden ist, deren zweiter Eingang mit dem Ausgang der zweiten Eingangsschnittstelle (103) für die Schätz-Einrichtung (9,30,32,31) verbunden ist, wobei die Zusatz-Vergleichseinrichtung (1051k) schaltungs- und/oder programmtechnisch dazu eingerichtet und/oder ausgebildet ist, eingegangene Signale, Daten oder Signal- oder Datenwerte auf Entsprechung miteinander nach vorbestimmten Kriterien zu vergleichen.

10. Überwachungsmodul nach Anspruch 9 **dadurch gekennzeichnet, dass** die dritte Eingangsschnittstelle (102,103,104) ein Differenzbildungs-Rechenwerk (1045k) umfasst, welches aus einem ersten und einem vorausgegangenen zweiten Eingangswert ausgangsseitig einen Differenzwert ausgibt, und die Zusatz-Vergleichseinrichtung (1051k) jeweils mit einem der Ausgänge. zweier Differenzbildungs-Rechenwerke(1033n,1022n;1033k,1045k) verbunden sind.

11. Sicherheitsanordnung mit einem Überwachungsmodul (101) nach Anspruch 8, 9, oder 10. das eingangsseitig mit einem Geber (G) für die Lage (ϕm), Geschwindigkeit und/oder Beschleunigung einer Antriebseinrichtung (Fig.1) verbindbar oder verbunden ist, **gekennzeichnet durch** eine Einrichtung (9,30;32,31) zum Schätzen der Lage (ϕe), Geschwindigkeit und/oder Beschleunigung anhand von Strommessungen (41,I1;42,I2) an der Antriebseinrichtung (Fig.1), wozu die Schätzeinrichtung (9,30;32,31) eine oder mehrere Eingangschnittstellen (33,34) für einen oder mehrere Stromsensoren (41,42) aufweist und ausgangseitig mit dem Überwachungsmodul (101) zur Zuführung von Schätzwerten (ϕe) gekoppelt ist.

12. Sicherheitsanordnung nach Anspruch 11, **gekennzeichnet durch** eine eingangsseitige Kopplung des Überwachungsmoduls (101) mit direkt an der Antriebsseinrichtung (Fig.1) angebrachte Stromsensoren (41,42).

## Claims

1. A method for monitoring a movement measurement on an electrical drive device (Fig.1) for plausibility, the movement measurement including recording output signals of a position, speed and/or acceleration sensor (G) sensing movements of the drive device, and the plausibility monitoring including the following steps:
a) measuring electric currents (41 ,i1 ;42,i2) in the drive device (Fig. 1), **characterised by** the further steps:
b) one or more estimated values (ϕe) are generated by means of the measurements for the electric currents (41 ,i1 ;42,i2) for the position, speed and/or acceleration of the drive device,
c) the estimated value or values (ϕe) is/are compared for equivalence to one or more measured values (ϕm) generated from the sensor output signals, from one sensor measured value (ϕm(n)) and one sensor measured value (ϕm(n-1)) preceding the latter a measured value difference (Δϕm(n)) being formed, and from a first and a second estimated value (ϕe(n), ϕe(n-1)) preceding the latter an estimated value difference (Δϕe(n)) being formed similarly, and the one or more sensor measured differences (Δϕm(n)) and the one or more estimated value differences (Δϕe(n)) being compared to one another for equivalence.

2. The method according to Claim 1, **characterised in that** the currents (i1, i2) of the drive device (Fig. 1) are exposed to or influenced by test signals from at least one test signal source (36).

3. The method according to Claim 2, **characterised in that** in order to generate the estimated value or values (ϕe) according to step a) an injection method also suitable for stand-still is used wherein the currents (11,i2) exposed to the test signal or signals are evaluated and/or filtered for position-dependent anisotropisms in the magnet structure of an electrical machine of the drive device (Fig. 1) and from this the position (ϕe), speed (ω_{ef}) and/or acceleration of the drive device is estimated.

4. The method according to Claim 1, 2 or 3, **characterised in that** an electric motor with a stator (1) through which the currents (i1,i2) flow is used for the drive device (Fig. 1), and in order to generate the estimated value or values according to step a) a mathematical machine model (9) is used with which a conclusion is drawn from the effect of a rotor back EMF influencing a stator current (iₗ,i₂) regarding the rotor speed (ωe) and/or position (ϕe) and a corresponding model speed value (13, 19, 23) or position value (ϕe) is generated.

5. The method according to any of the preceding claims, an electric motor with a stator (1) through which the currents (i1,i2) flow being used for the drive device (Fig. 1), **characterised by** optionally additional plausibility monitoring wherein the stator currents (i1,i2) are measured (41,42) and the resulting stator current measured values are evaluated such as to form a stator space vector (ise^{jϕs}), and the one or more estimated values (ϕe) which result from the current measurements (41,i1;42,i2) in the drive device (Fig. 1) for determining the position, speed and/or acceleration of the drive device (Fig. 1), and/or the sensor measured values (ϕm) for the position, speed and/or acceleration of the drive device are compared for equivalence to the position (ϕS), speed and/or acceleration of the stator space vector (ise^{jϕs}).

6. The method according to Claim 5, **characterised in that** from an angular position (ϕS(k)), angular speed and/or angular acceleration of the stator space vector (ise^{jϕe}) and an angular position (ϕS(k-1)), angular speed and/or angular acceleration of the stator space vector (ise^{jϕs}) preceding the latter a difference value (ΔϕS(k)) for the position, speed and/or acceleration change of the stator space vector (ise^{jϕs}) is formed and respectively from a first and a second measured value (Δϕm(n), Δϕm(n-1)) preceding the latter a measured value difference (Δϕm), and/or from a first and a second estimated value (ϕe(k) ϕe(k-1)) preceding the latter one or more estimated value differences (Δϕe(n), Δϕe(k)) are formed similarly, and the measured values and/or estimated value differences (Δϕe(k)) are compared with the stator space vector difference value (Δϕs(k)) for equivalence.

7. The method according to any of the preceding claims, **characterised in that** the switching-on paths or other switching-on means of the drive device (Fig. 1) and/or a control for switching-off means (OFF) for the drive device or other safety means or measures are blocked or interrupted when lack of equivalence is detected in a plausibility comparison (105).

8. A monitoring module (101) for an electrical drive device (Fig. 1) comprising a position, speed and/or acceleration sensor (G) and comprising a comparison device (1051 n) or other plausibilisation functional unit (105) the circuits and/or programmes of which are set up and/or formed to compare inputted signals, data or signal and data values for equivalence to one another according to pre-determined criteria, the monitoring module (101) having at least one first input interface (102) for a movement sensor system (G) and at least one output interface (106,OFF) for controlling switching-off means for the drive device (Fig. 1) or other safety means, in particular for implementing the method according to any of the preceding claims, **characterised in that** the monitoring module (101) has a device (9,30:32,31) for estimating the position (ϕe), speed and/or acceleration by means of internal current measurements (41,i1;42,i2) and a second input interface (103) for the output (ϕe) of the estimating device (9,30;32,31) and connected to the outputs of the first and the second input interface (102,103) is at least one input of the comparison device (1051 n) or other plausibilisation functional unit (105), the first and second input interface (102, 103) respectively comprising a difference formation calculator (1 022n, 1033n, 1033k) which issues a difference value on the output side from a first and a preceding second input value, and the comparison device (1051 n) is respectively connected to one of the outputs of two difference formation calculators (1033n,1022n).

9. The monitoring module according to Claim 8, **characterised by** a third input interface (104) designed to receive current measured values (i1,i2,i3) to or into which a calculating device (1044) is connected or structurally and/or functionally integrated on the input side, the circuits and/or programmes of which are set up and/or formed to determine a current or voltage space vector (ise^{jϕe}) from the current measured values (i1,i2) and to make available on the output side a value (ϕs) for its position, speed and/or acceleration, and the output of this calculating device (1044) is connected indirectly or directly to a first input of an additional comparison device (1051 k) the second input of which is connected to the output of the second input interface (103) for the estimating device (9,30;32,31), the circuits and/or programmes of the additional comparison device (1051 k) being set up and/or formed to compare inputted signals, data or signal or data values for equivalence to one another according to predetermined criteria.

10. The monitoring module according to Claim 9, **characterised in that** the third input interface (102,103,104) comprises a difference forming calculator (1045k) which issues on the output side a difference value from a first and a preceding second input value and the additional comparison device (1051 k) is respectively connected to one of the outputs of two difference forming calculators (1033n,1022n;1033k,1045k).

11. A safety system comprising a monitoring module (101) according to Claim 8, 9 or 10 that can be connected or is connected on the input side to a sensor (G) for the position (ϕm), speed and/or acceleration of a drive device (Fig. 1), **characterised by** a device (9,30;32,31) for estimating the position (ϕre), speed and/or acceleration by means of current measurements (41,i1;42,i2) on the drive device (Fig. 1), for which purpose the estimating device (9,30;32,31) has one or more input interfaces (33,34) for one or more current sensors (41,42) and is coupled on the output side to the monitoring module (101) for supplying estimated values (ϕe).

12. The safety system according to Claim 11, **characterised by** an input-side coupling of the monitoring module (101) to current sensors (41,42) applied directly to the drive device (Fig. 1).

## Revendications

1. Procédé de contrôle de plausibilité d'une mesure de mouvement sur un dispositif d'entraînement électrique (Fig. 1), dans lequel la mesure de mouvement comprend une détection de signaux de sortie d'un capteur de position, de vitesse et/ou d'accélération (G) détectant des mouvements du dispositif d'entraînement, le contrôle de plausibilité comprenant l'étape suivante de :
a) mesure des courants électriques (41,i1; 42,i2) dans le dispositif d'entraînement (Fig. 1),
procédé **caractérisé par** les autres étapes suivantes consistant à :
b) produire, à l'aide des mesures des courants électriques (41,i1 ; 42,i2), une ou plusieurs valeurs estimées (ϕe) de position, de vitesse et/ou d'accélération du dispositif d'entraînement,
c) comparer la ou les valeurs estimées (ϕe) avec une ou plusieurs valeurs mesurées (ϕm) issues des signaux de sortie du capteur pour en déterminer l'équivalence, une différence de valeurs mesurées (Δϕm(n)) étant formée à partir d'une valeur mesurée de capteur (ϕm(n)) et d'une valeur mesurée de capteur (ϕm(n-1)) précédant celle-ci, et de manière analogue une différence de valeurs estimées (Δϕe(n)) étant formée à partir d'une première valeur estimée et d'une deuxième valeur estimée précédant celle-ci (ϕe(n), ϕe(n-1)), et comparer la ou les différences de valeurs mesurées de capteur (Δϕm(n)) et la ou les différences de valeurs estimées (Δϕe(n)) entre elles pour en déterminer l'équivalence.

2. Procédé selon la revendication 1, **caractérisé en ce que** les courants (il, i2) du dispositif d'entraînement (Fig. 1) sont soumis à ou influencés par des signaux de test provenant d'au moins une source de signaux de test (36).

3. Procédé selon la revendication 2, **caractérisé en ce que** l'on utilise pour produire la ou les valeurs estimées (ϕe) selon l'étape a) un procédé d'injection qui convient également à un arrêt machine, dans lequel les courants (il, i2) soumis au signal ou aux signaux de test sont évalués et/ou filtrés par rapport à des anisotropies dépendantes de la position dans la structure magnétique d'une machine électrique du dispositif d'entraînement (Fig. 1), et que l'on en déduit une estimation de la position (ϕe), la vitesse (ω_{ef}) et/ou l'accélération du dispositif d'entraînement.

4. Procédé selon la revendication 1, 2 ou 3, **caractérisé en ce qu'**est utilisé, pour le dispositif d'entraînement (Fig. 1), un moteur électrique pourvu d'un stator (1) traversé par les courants (il, i2), et pour la production de la ou des valeur(s) estimée(s) selon l'étape a), un modèle mathématique de machine (9), dans lequel, à partir de l'influence d'une force contre-électromotrice du rotor influant sur un courant de stator (il, i2), est déduite la vitesse (ωe) et/ou la position (ϕe) du rotor et est générée une valeur de vitesse de modèle (13, 19, 23) ou une valeur de position (ϕe) correspondante.

5. Procédé selon l'une des revendications précédentes, dans lequel est utilisé, pour le dispositif d'entraînement (Fig. 1), un moteur électrique pourvu d'un stator (1) traversé par les courants (il, i2), **caractérisé par** un contrôle de plausibilité éventuellement supplémentaire, lors duquel les courants de stator (iₗ,i₂) sont mesurés (41, 42) et les valeurs mesurées de courants de stator résultantes sont évaluées pour former un vecteur spatial de stator (Ise^{jϕS}), et la ou les valeurs estimées (ϕe) résultant des mesures de courant (41,i1 ; 42 ; i2) dans le dispositif d'entraînement (Fig. 1) pour la détermination de la position, vitesse et/ou accélération du dispositif d'entraînement (Fig. 1), et/ou les valeurs mesurées de capteur (ϕm) pour la position, la vitesse et/ou l'accélération du dispositif d'entraînement sont comparées avec la position (ϕe), la vitesse et/ou l'accélération du vecteur spatial de stator (Ise^{jϕS}) pour en déterminer l'équivalence.

6. Procédé selon la revendication 5, **caractérisé en ce que** sont formées, à partir d'une position angulaire (ϕS(k)), vitesse angulaire et/ou accélération angulaire du vecteur spatial de stator (Ise^{jϕS}) et d'une position angulaire (ϕS(k-1)), vitesse angulaire et/ou accélération angulaire du vecteur spatial de stator (Ise^{jϕS}) précédant celle-ci, une valeur différentielle (ΔϕS(k)) de variation de position, de vitesse et/ou d'accélération du vecteur spatial de stator (Ise^{jϕS}), et respectivement de manière analogue à partir d'une première valeur mesurée et d'une deuxième valeur mesurée précédant celle-ci (Δϕm(n), (Δϕm(n-1)), une différence de valeurs mesurées (Δϕm), et/ou à partir d'une première valeur estimée et d'une deuxième valeur estimée précédant celle-ci (ϕe(k), (ϕe(k-1)), une ou plusieurs différences de valeurs estimées (Δϕe(n), (Δϕe(k)), et les différences de valeurs mesurées et/ou les différences de valeurs estimées (Δϕe(k) sont comparées avec la valeur différentielle (Δϕs(k)) du vecteur spatial de stator pour en déterminer l'équivalence.

7. Procédé selon l'une des revendications précédentes, **caractérisé en ce que** s'opèrent un blocage ou une interruption des chemins de mise en circuit ou autres moyens de mise en circuit du dispositif d'entraînement (Fig. 1) et/ou une commande de moyens de mise hors circuit (OFF) du dispositif d'entraînement ou d'autres moyens ou mesures de sécurité, lorsqu'une absence d'équivalence est constatée lors d'une comparaison de plausibilité (105).

8. Module de contrôle (101) d'un dispositif d'entraînement électrique (Fig. 1), doté d'un capteur de position, de vitesse et/ou d'accélération (G) et d'un dispositif comparateur (1051n) ou autre unité fonctionnelle de plausibilisation (105), qui est réglé(e) et/ou conçu(e) du point de vue de la technique des circuits ou de programmation pour comparer entre eux, afin d'en déterminer l'équivalence, des signaux, caractéristiques ou valeurs de signaux ou de caractéristiques reçus, selon des critères prédéfinis, le module de contrôle (101) présentant au moins une première interface d'entrée (102) pour des capteurs de mouvement (G) et au moins une interface de sortie (106, OFF) pour la commande de moyens de mise hors circuit du dispositif d'entraînement (Fig. 1) ou d'autres moyens de sécurité, en particulier pour la réalisation du procédé selon l'une des revendications précédentes, **caractérisé en ce que** le module de contrôle (101) présente un dispositif(9,30; 32,31) destiné à estimer la position (ϕe), la vitesse et/ou l'accélération à l'aide de mesures de courants internes (41,i1 ; 42,i2), et une deuxième interface d'entrée (103) pour la sortie (ϕe) du dispositif d'estimation (9,30 ; 32,31), et **en ce qu'**au moins une entrée du dispositif comparateur (1051n) ou autre unité fonctionnelle de plausibilisation (105) est reliée aux sorties de la première et de la deuxième interfaces d'entrée (102, 103), la première et la deuxième interfaces d'entrée (102, 103) comprenant respectivement une unité arithmétique de formation de différence (1022n, 1033n, 1033k) qui émet, côté sortie, une valeur différentielle à partir d'une première valeur d'entrée et d'une deuxième valeur d'entrée précédente, et le dispositif comparateur (1051n) est relié respectivement à l'une des sorties de deux unités arithmétiques de formation de différence (1033n, 1022n).

9. Module de contrôle selon la revendication 8, **caractérisé par** une troisième interface d'entrée (104) conçue pour recevoir des valeurs de mesure de courant (il,i2,i3), à laquelle est relié ou intégré structurellement et/ou fonctionnellement, côté entrée, un dispositif de calcul (1044) qui est réglé et/ou conçu du point de vue de la technique des circuits ou de programmation pour déterminer, à partir des valeurs de mesure de courant (i1 ,i2), un vecteur spatial de courant ou de tension (Ise^{jϕS}) et pour délivrer, côté sortie, une valeur (ϕs) de sa position, vitesse et/ou accélération, et la sortie de ce dispositif de calcul (1044) est indirectement ou directement reliée à une première entrée d'un dispositif comparateur supplémentaire (1051k), dont la deuxième entrée est reliée à la sortie de la deuxième interface d'entrée (103) du dispositif d'estimation (9,30 ; 32,31), le dispositif comparateur supplémentaire (1051k) étant réglé et/ou conçu du point de vue de la technique des circuits et de programmation pour comparer entre eux, afin d'en déterminer l'équivalence, des signaux, caractéristiques ou valeurs de signaux ou caractéristiques reçus, selon des critères prédéfinis.

10. Module de contrôle selon la revendication 9, **caractérisé en ce que** la troisième interface d'entrée (102, 103, 104) comprend une unité arithmétique de formation de différence (1045k) qui émet, côté sortie, une valeur différentielle à partir d'une première valeur d'entrée et d'une deuxième valeur d'entrée précédente, et le dispositif comparateur supplémentaire (1051k) est relié respectivement à l'une des sorties de deux unités arithmétiques de formation de différence (1033n, 1022n ; 1033k, 1045k).

11. Agencement de sécurité doté d'un module de contrôle (101) selon la revendication 8, 9 ou 10, qui peut être relié ou qui est relié, côté entrée, à un capteur (G) de position (ϕm), vitesse et/ou accélération d'un dispositif d'entraînement (Fig. 1), **caractérisé par** un dispositif (9,30; 32,31) destiné à estimer la position (ϕe), vitesse et/ou accélération à l'aide de mesures de courant (41,i1 ; 42,i2) sur le dispositif d'entraînement (Fig.1), le dispositif d'estimation (9,30 ; 32,31) présentant, à cet effet, une ou plusieurs interfaces d'entrée (33, 34) d'un ou plusieurs capteurs de courant (41, 42) et étant couplé, côté sortie, au module de contrôle (101) pour l'acheminement de valeurs estimées (ϕe).

12. Agencement de sécurité selon la revendication 11, **caractérisé par** un couplage, côté entrée, du module de contrôle (101) avec des capteurs de courant (41, 42) disposés directement sur le dispositif d'entraînement (Fig. 1).
